(19) Europäisches Patentamt

European Patent Office

Office européen des brevets

(11) **EP 4 733 793 A2**

## (12) EUROPEAN PATENT APPLICATION

(43) Date of publication:
**29.04.2026 Bulletin 2026/18**

(21) Application number: **25199914.0**

(22) Date of filing: **03.09.2025**

(51) International Patent Classification (IPC):
**G01R 33/00** $^{(2006.01)}$   **G01R 33/07** $^{(2006.01)}$
**G01R 33/09** $^{(2006.01)}$

(52) Cooperative Patent Classification (CPC):
**G01R 33/0005; G01R 33/0029; G01R 33/0041;**
**G01R 33/07; G01R 33/09**

(84) Designated Contracting States:
**AL AT BE BG CH CY CZ DE DK EE ES FI FR GB**
**GR HR HU IE IS IT LI LT LU LV MC ME MK MT NL**
**NO PL PT RO RS SE SI SK SM TR**
Designated Extension States:
**BA**
Designated Validation States:
**GE KH LA MA MD TN**

(30) Priority: **22.10.2024 US 202418922607**

(71) Applicant: **Allegro MicroSystems, LLC**
**Manchester, NH 03103 (US)**

(72) Inventor: **ROMERO, Hernán D.**
**1640 Buenos Aires (AR)**

(74) Representative: **South, Nicholas Geoffrey**
**Venner Shipley LLP**
**200 Aldersgate**
**London EC1A 4HD (GB)**

## (54) HIGH-ACCURACY SENSOR WITH HETEROGENEOUS ARCHITECTURE

(57) A sensor, comprising: a first signal path including a plurality of magnetoresistance (MR) elements, the first signal path being configured to generate a first signal based, at least in part, on an output of the MR elements, the output of the MR elements being generated, at least in part, in response to an external magnetic field that is incident on the sensor and a first feedback magnetic field; a second signal path including one or more Hall elements, the second signal path being configured to generate a second signal based, at least in part, on an output of the Hall elements; a first feedback coil that is configured to generate the first feedback magnetic field, the first feedback coil being driven with a first drive current, the first drive current being generated, at least in part, based on the first signal.

FIG. 1A

EP 4 733 793 A2

**Description**

BACKGROUND

As is known, sensors are used to perform various functions in a variety of applications. Some sensors include one or more electromagnetic flux sensing elements, such as a Hall effect element, a magnetoresistive element, or a receiving coil to sense an electromagnetic flux associated with a quantity that is desired to be monitored. Sensor integrated circuits are widely used in automobile control systems and other safety-critical applications. There are a variety of specifications that set forth requirements related to permissible sensor quality levels, failure rates, and overall functional safety.

SUMMARY

According to aspects of the disclosure, a sensor is provided, comprising: a first signal path including a plurality of magnetoresistance (MR) elements, the first signal path being configured to generate a first signal based, at least in part, on an output of the MR elements, the output of the MR elements being generated, at least in part, in response to an external magnetic field that is incident on the sensor and a first feedback magnetic field; a second signal path including one or more Hall elements, the second signal path being configured to generate a second signal based, at least in part, on an output of the Hall elements, the output of the Hall elements being generated at least in part based on the external magnetic field; a first feedback coil that is configured to generate the first feedback magnetic field, the first feedback coil being driven with a first drive current, the first drive current being generated, at least in part, based on the first signal; and a combination circuit that is configured to combine the first signal and the second signal to produce an output signal, the output signal being generated at least in part based on the first signal and the second signal.

In an embodiment, the first signal path includes one or more blocking capacitors that are configured to remove a first offset from the output of the MR elements, and the second signal path includes a modulator and a demodulator that are configured to perform frequency chopping on the output of the Hall elements to remove a second offset from the output of the Hall elements.

In an embodiment, the combination circuit is configured to combine the first signal by adding the first signal to the second signal and filtering a resulting sum with a filter that is arranged to correct for notching that is present in combined frequency responses of the first signal path and the second signal path.

In an embodiment, the first signal path is arranged in a closed-loop configuration, the second signal path is arranged in an open-loop configuration, and the first feedback coil is positioned in greater proximity to the MR elements than the Hall elements.

In an embodiment, the first feedback coil is configured to surround the MR elements.

In an embodiment, a second feedback coil that is configured to generate a second feedback magnetic field, the second feedback coil being driven with a second drive current, the second drive current being generated, at least in part, based on the second signal.

In an embodiment, the second feedback coil is configured to surround the Hall elements.

In an embodiment, the first and second signal paths are arranged to have substantially the same gain.

In an embodiment, the combination circuit includes a first summation element and a second summation element, the first summation element being configured to generate an auxiliary signal by subtracting the second signal from the first signal, and the second summation element being configured to generate the output signal by subtracting the auxiliary signal from the first signal.

In an embodiment, the first and second signal paths are arranged to have substantially the same gain.

In an embodiment, the first drive current is generated based on both the first signal and the second signal, the combination block includes a summation circuit that is configured to generate the output signal by subtracting the second signal from the first signal, the first signal path has a first gain, and the second signal path has a second gain that is two or more times greater than the first gain.

In an embodiment, the first gain is at least one order of magnitude greater than the first gain.

In an embodiment, the second gain is at least two orders of magnitude greater than the second gain.

In an embodiment, the first feedback coil is configured to surround both the MR elements and the Hall elements.

According to aspects of the disclosure, a sensor is provided, comprising: a first signal path including a plurality of magnetoresistance (MR) elements, the first signal path being configured to generate a first signal based, at least in part, on the output of the MR elements, the output of the MR elements being generated, at least in part, in response to an external magnetic field that is incident on the sensor and a feedback magnetic field; a second signal path including one or more Hall elements, the second signal path being configured to generate a second signal based, at least in part, on an output of the Hall elements, the output of the Hall elements being generated at least in part based on the external magnetic field; and a feedback coil that is configured to generate the feedback magnetic field, the feedback coil being driven with a drive current, the drive current being generated, at least in part, based on the first signal; and a combination circuit that is configured to generate an output signal by adding the first signal to the second signal to produce a third signal and filtering the third signal with a filter that is arranged to correct for notching in a frequency response of the third signal.

In an embodiment, the first signal path has substantially the same gain as the second signal path.

In an embodiment, each of the MR elements includes at least one of a giant magnetoresistance (GMR) element, and each of the Hall elements includes one of a planar Hall element or a vertical Hall element.

In an embodiment, the Hall elements are disposed on the side of the feedback coil, and the feedback coil is configured to surround the MR elements.

According to aspects of the disclosure, a sensor is provided, comprising: a first signal path including a plurality of magnetoresistance (MR) elements, the first signal path being configured to generate a first signal based, at least in part, on the output of the MR elements, the output of the MR elements being generated, at least in part, in response to an external magnetic field that is incident on the sensor and a first feedback magnetic field; a second signal path including one or more Hall elements, the second signal path being configured to generate a second signal based, at least in part, on an output of the Hall elements, the output of the Hall elements being generated at least in part based on the external magnetic field; and a first feedback coil that is configured to generate the first feedback magnetic field, the first feedback coil being driven with a first drive current, the first drive current being generated, at least in part, based on the first signal; a second feedback coil that is configured to generate the second feedback magnetic field, the second feedback coil being driven with a second drive current, the second drive current being generated, at least in part, based on the second signal; and a combination circuit that is configured to generate an output signal by adding the first signal to the second signal to produce a third signal and filtering the third signal with a filter that is arranged to correct for notching in a frequency response of the third signal.

In an embodiment, the first signal path has substantially the same gain as the second signal path.

In an embodiment, each of the MR elements includes at least one of a giant magnetoresistance (GMR) element, and each of the Hall elements includes one of a planar Hall element or a vertical Hall element.

In an embodiment, the first feedback coil is configured to surround the MR elements and the second feedback coil is configured to surround the Hall elements.

In an embodiment, the first drive current is generated independently of the second signal, and the second drive current is generated independently of the first signal.

In an embodiment, the first signal path includes one or more blocking capacitors that are configured to remove a first offset that is present in an output of the MR elements, and the second signal path includes a modulator and a demodulator, the modulator and demodulator being configured to perform frequency chopping on an output of the Hall elements.

According to aspects of the disclosure, a sensor is provided, comprising: a first signal path including a plurality of magnetoresistance (MR) elements, the first signal path being configured to generate a first signal based, at least in part, on the output of the MR elements, the output of the MR elements being generated, at least in part, in response to an external magnetic field that is incident on the sensor and a first feedback magnetic field; a second signal path including one or more Hall elements, the second signal path being configured to generate a second signal based, at least in part, on an output of the Hall elements, the output of the Hall elements being generated at least in part based on the external magnetic field; a first feedback coil that is configured to generate the first feedback magnetic field, the first feedback coil being driven with a first drive current, the first drive current being generated, at least in part, based on the first signal; a second feedback coil that is configured to generate the second feedback magnetic field, the second feedback coil being driven with a second drive current, the second drive current being generated, at least in part, based on the second signal; and a combination circuit that is configured to generate an output signal based on the first signal to the second signal, the combination circuit including a first summation element and a second summation element, the first summation element being configured to generate an auxiliary signal by subtracting the second signal from the first signal, and the second summation element being configured to generate the output signal by subtracting the auxiliary signal from the first signal.

In an embodiment, the second gain is at least two orders of magnitude greater than the first gain.

In an embodiment, each of the MR elements includes at least one of a giant magnetoresistance (GMR) element, and each of the Hall elements includes one of a planar Hall element or a vertical Hall element.

In an embodiment, the first feedback coil is configured to surround the MR elements and the second feedback coil is configured to surround the Hall elements.

In an embodiment, the first drive current is generated independently of the second signal, and the second drive current is generated independently of the first signal.

In an embodiment, the second signal path includes a modulator and a demodulator, the modulator and demodulator being configured to perform frequency chopping on an output of the Hall elements.

According to aspects of the disclosure, a sensor is provided comprising: a first signal path having a first gain, the first signal path including a plurality of magnetoresistance (MR) elements, the first signal path being configured to generate a first signal based, at least in part, on the output of the MR elements, the output of the MR elements being generated, at least in part, in response to an external magnetic field that is incident on the sensor and a feedback magnetic field; a second signal path having a second gain that is at least one order of magnitude greater than the first gain, the second signal path including one or more Hall elements, the second signal path being configured to generate a second signal based, at least in part, on an output of the Hall elements, the output of the Hall elements being generated at least in part based on the external magnetic field; and a feedback coil that is configured to generate the feedback magnetic field, the feedback coil being driven with a drive current, the drive current being generated, at least in part, based on both of the first signal and the second signal; and a combination circuit that is configured to generate an output signal based on the first signal and the second signal, the combination circuit including a summation element that is configured to generate the output signal by subtracting the second signal from the first signal.

In an embodiment, the second gain is at least two orders of magnitude greater than the first gain.

In an embodiment, the second signal path includes a modulator and a demodulator, the modulator and demodulator being configured to perform frequency chopping on an output of the Hall elements.

In an embodiment, the feedback coil is configured to surround both the MR elements and the Hall elements.

## BRIEF DESCRIPTION OF THE DRAWINGS

The foregoing features may be more fully understood from the following description of the drawings in which:

FIG. 1A is a diagram of an example of a sensor, according to aspects of the disclosure;

FIG. 1B is a diagram illustrating aspects of the operation of the sensor of FIG. 1A, according to aspects of the disclosure;

FIG. 1C is a diagram illustrating aspects of the operation of the sensor of FIG. 1A, according to aspects of the disclosure;

FIG. 1D is a diagram illustrating aspects of the operation of the sensor of FIG. 1A, according to aspects of the disclosure;

FIG. 1E is a diagram illustrating aspects of the operation of the sensor of FIG. 1A, according to aspects of the disclosure;

FIG. 1F is a schematic diagram of a sensor, according to aspects of the disclosure;

FIG. 2A is a diagram of an example of a sensor, according to aspects of the disclosure;

FIG. 2B is a schematic diagram of a sensor, according to aspects of the disclosure;

FIG. 3A is a diagram of an example of a sensor, according to aspects of the disclosure;

FIG. 3B is a schematic diagram of a sensor, according to aspects of the disclosure;

FIG. 4A is a diagram of an example of a sensor, according to aspects of the disclosure; and

FIG. 4B is a schematic diagram of a sensor, according to aspects of the disclosure.

## DETAILED DESCRIPTION

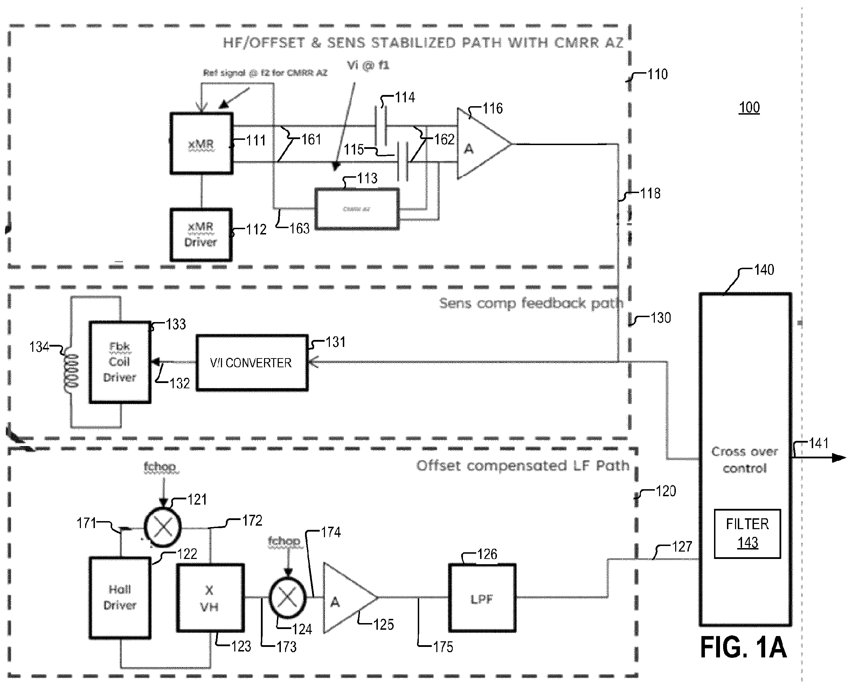

FIG. 1A is a diagram of a magnetic field sensor 100, according to aspects of the disclosure. Sensor 100 may include a position sensor, a current sensor, a speed sensor, and/or any other suitable type of magnetic field sensor.

According to the present disclosure, sensor 100 features a heterogeneous architecture. Specifically, sensor 100 includes a first signal path 110 which utilizes one or more magnetoresistors as its sensing elements, and a second signal path 120 which utilizes one or more Hall elements as its means for sensing magnetic fields. The signal path 110 (*i.e.,* the MR path) provides sensitivity stability by means of feedback path 130, and is an AC-coupled path (*e.g.,* by virtue of having block capacitors 114 and 115, which prevent DC signals from passing through. However, the signal path 110 lacks sufficient sensitivity for low-frequency (and/or DC) signals. On the other hand, signal path 120 (*i.e.,* the Hall path) has higher sensitivity with respect to low-frequency signals, but it lacks sufficient sensitivity stability over time, as the Hall element ages and its accuracy is degraded. Moreover, the signal path 120 uses frequency chopping to modulate the signal that is output from the Hall elements, and for this reason it contains low amounts of offset in its output. Conversely, the signal path 110 is susceptible to containing larger amounts of offset in its output. The discussion that follows provides various techniques for combining the outputs of the signal path 110 and the signal path 120 to produce a single output signal, while removing offset that might otherwise be present in the output signal and addressing cross-over issues, such as notching.

According to the example of FIG. 1A, signal path 110 is used to sense magnetic field signals below a frequency threshold T (*e.g.,* 100 KHz) and the second signal path 120 is used to sense magnetic field signals that are above the frequency threshold T. The output signal 118 of the first signal path 110 is combined with the output signal 127 of the second signal path 120 by a crossover control circuit 140 (hereinafter "crossover 140"). The crossover may produce an output signal 141 based on the signals 118 and 127, and provide the output signal 141 to external circuitry that is coupled to sensor 100. The output signal may be indicative of the level of a magnetic field of interest that is being measured with sensor 100. By way of example, the output signal 141 may also be indicative of the level of an electrical current through a conductor, the speed of a target, the position of a target, and/or any other suitable quantity that is normally measured by using magnetic field sensors.

Sensor 100 may include a feedback path 130 whose purpose is to correct for changes in the sensitivity of the signal path 110. Feedback path 130 may include a voltage-to-current (V/I) converter 131, a feedback coil driver 133, and a feedback coil 134. The V/I converter 131 may be configured to receive the signal 118 and generate a control signal 132 in response. The signal 132 is provided to feedback coil driver 133 where it is used by the feedback coil driver 133 to drive the feedback coil 134. Signal 132 may specify the level of electrical current that is required to be passed through the feedback coil 134 and/or the level of feedback magnetic field that is to be generated by the feedback coil 134.

Signal path 110 may include a driver circuit 112, a sensing bridge 111, a control circuit 113, blocking capacitors 114 and 115, and an amplifier 116. The sensing bridge 111 may include any suitable type of full-bridge or half-bridge circuit. The sensing bridge 111 may include one or more magnetoresistance (MR) elements. Each of the MR elements may include a giant magnetoresistance (GMR) element or a tunnelling magnetoresistance (TMR) element, and/or any other suitable type of magnetoresistor. Control circuit 113 may include any suitable type of circuit that is configured to equalize the respective resistances of the MR elements in sensing bridge 111. The control circuit 113 may be configured to reduce (or ideally remove) any sensitivity mismatch that is present between the MR elements in the sensing bridge 111. If there is a sensitivity mismatch in the sensing bridge 111, the common mode rejection ratio (CMRR) of the sensing bridge 111 would be degraded, so the control circuit 113 may be used to prevent such degradation by adjusting the individual resistances of the MR elements that constitute the sensing bridge 111. Further information about the implementation of control circuit 113 can be found in U.S. Patent Application 18/527,675, entitled Low Residual Offset Sensor, which is herein incorporated by reference in its entirety.

In operation, sensing bridge 111 may be configured to sense a magnetic field signal and generate a sensing signal 161 in response. Blocking capacitors 114 and 115 may be configured to generate a signal 162 based on signal 161 by removing an offset (which is presented as a DC component) in signal 161. In addition the blocking capacitors may implement a high pass filter as a collateral consequence to blocking DC offset that is present in signal 161. Since the size of each capacitor 114 and 115 determines the level of filtering, this is a design variable that can be adjusted depending on the application. The amplifier 116 may be configured to amplify the signal 162 to produce the output signal 118 of the signal path 110. The control circuit 113 may be configured to generate a control signal 163 based on the signal 162 and provide the control signal 163 to the sensing bridge 111. Depending on the value of the control signal 163, sensing bridge 111 may adjust the sensitivity of one or more MR elements in sensing bridge 111 to improve the CMRR of sensing bridge 111.

The second signal path 120 may include a modulator 121, a driver circuit 122, one or more Hall elements 123, a demodulator 124, an amplifier 125, and a low-pass filter (LPF) 126. The driver circuit 122 may include any circuitry that is configured to supply power to the Hall elements 123. According to the present example, Hall elements 123 are vertical Hall elements. However, alternative implementations are possible in which Hall elements 123 are planar Hall elements. The low-pass filter 126 may have a cutoff frequency that is equal to (or otherwise based on) the frequency of threshold T.

In operation, driver circuit 122 may provide a signal 171 to modulator 121. Modulator 121 may modulate signal 171 based on a signal fchop to produce a signal 172, which is subsequently used to drive Hall elements 123. Hall elements 123 may sense a magnetic field and generate a signal 173 in response. Signal 173 may be demodulated by demodulator 124 based on the signal fchop to produce a signal 174. Signal 174 may be amplified by amplifier 125 to produce a signal 175. Signal 175 may be filtered by LPF 126 to produce the output signal 127.

The operation of the architecture shown in FIG. 1A may be described by equations 1-3 below.

$$S_{118} = \frac{B_{ext(HF)}}{K_{fbkMR} * d_{TMR}} \quad (1)$$

$$S_{127} = B_{ext(LF)} * S \quad (2)$$

$$S_{141} = S_{118} + S_{127} \quad (3)$$

where $S_{118}$ is the value of signal 118, $S_{127}$ is the value of signal 127, $S_{141}$ is the value of signal 141, $B_{ext(HF)}$ is the magnitude of a high-frequency component of the external magnetic field that is being measured, $K_{fbkTMR}$ is a coupling coefficient representing the transfer of energy between the feedback coil 134 and the sensing bridge 111 (measured in gauss per ampere), $d_{MR}$ is a scaling factor or gain, $B_{ext(LF)}$ is the magnitude of the low-frequency component of the magnetic field that is being measured, and S is the sensitivity of the Hall elements 123. In the present example, the frequency components of the magnetic field whose value is below the threshold T are considered low-frequency components and the frequency components of the magnetic field whose value is above the threshold T are considered high-frequency components.

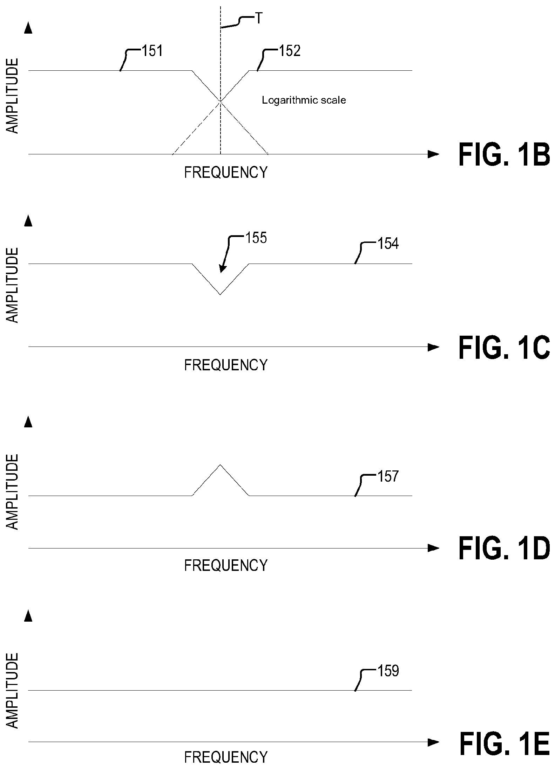

FIG. 1B shows a curve 151 which represents the frequency response of signal path 120 (*i.e.,* the frequency response of signal 127), and a curve 152 which represents the frequency response of signal path 110 (*i.e.,* the frequency response of signal 118). Also shown in FIG. 1B is the value of threshold T. The dashed portions of curves 152 and 151 may represent the frequency components that are being filtered by blocking capacitors 114 and 115, and the low-pass filter 126, respectively. Although, in the present example, the dashed portions are filtered in some implementations they may be left unfiltered. Because FIG. 1B features a logarithmic scale, the addition of these portions to the sum of signals 118 and 127 may be negligible. In sum, FIG. 1B shows that the frequency response of signal path 120 slumps towards the beginning of the low-frequency range (*i.e.,* the range including frequencies that are lower than threshold T), while the frequency response of signal path 110 lags at the beginning of the high frequency range (*i.e.,* the range including frequencies that are larger than the threshold T).

FIG. 1C shows the plot of a curve 154, which represents signal 141, when signal 141 is calculated in accordance with equation 3 above. As illustrated, curve 154 includes a notch 155 which results from the slump/lag in signals 118 and 127. Having such a notch in the frequency response of crossover 140 is undesirable as it could compromise the accuracy of sensor 100. For this reason, crossover 140 may include a filter 143 which is arranged to rectify the notch. The response of filter 143 is represented by curve 157, which is shown in FIG. 1D. The output of filter 143 is represented by curve 159, which is shown in FIG. 1E. Figure 1E is provided to illustrate that the application of filter 143 to the sum of the outputs of signals paths 110 and 120 may produce a flat response of sensor 100 across the entire range of frequencies of interest for sensor 100. In some respects, FIGS. 1B-E are provided to illustrate an example of a cross-over issue, which is herein referred to as "notching", and which is manifested in the combination of signal paths 110 and 120 having a non-uniform frequency response. In the example of FIG. 1C, the non-uniformity in the combination of signals 118 and 127 (*i.e.,* the non-uniformity in the frequency response of signal 141) is manifested by notch 155.

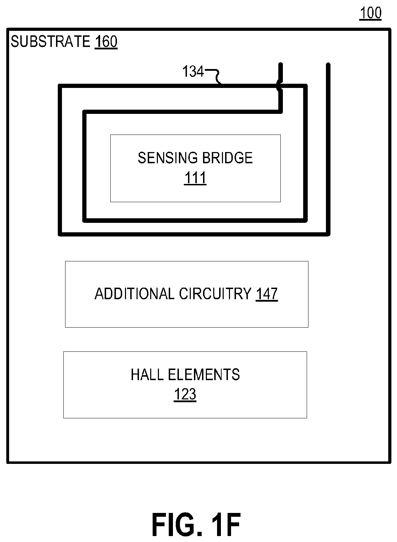

FIG. 1F is a diagram of sensor 100 when sensor 100 is arranged in accordance with the design of FIG. 1A. As illustrated, sensor 100 may include a substrate 160. The substrate 160 may be a silicon substrate and/or any other suitable type of substrate. Formed on the substrate may be the feedback coil 134, additional circuitry 147, and Hall elements 123. Feedback coil 134 may be implemented as a conductive trace defining one or more turns. The additional circuitry 147 may include all components of sensor 100 that are shown in FIG. 1A, except for feedback coil 134, sensing bridge 111, and Hall elements 123. In the example of FIG. 1F, feedback coil 134 is arranged to surround the sensing bridge 111, while Hall elements 123 are situated outside of feedback coil 134. Although, in the present example, feedback coil 134 is configured to surround sensing bridge 111, alternative implementations are possible in which feedback coil 134 is situated to the side of sensing bridge 111. Additionally or alternatively, in some implementations, feedback coil 134 may be situated in greater proximity to sensing bridge 111 than Hall elements 123. In some implementations, feedback coil 134 may be configured in such a way so as to cause the impact of the magnetic field generated by feedback coil 134 on Hall elements 123 to be minimized or ideally become nonexistent. FIG. 1F is provided to illustrate that in the example of FIG. 1A sensing bridge 111 is arranged in a closed-loop configuration while Hall elements 123 are arranged in an open-loop configuration. Under the nomenclature of the present disclosure, a sensing module (such as sensing bridge 111 or Hall elements 123) is arranged in a closed-loop configuration when the sensing module is subjected to a feedback magnetic field that is at least partially generated based on a signal that is output by the sensing module. Under the nomenclature of the present disclosure, a sensing module (such as sensing bridge 111 or Hall elements 123) is arranged in an open-loop configuration when the sensing module is not subjected to a feedback magnetic field that is at least partially generated based on a signal that is output by the sensing module.

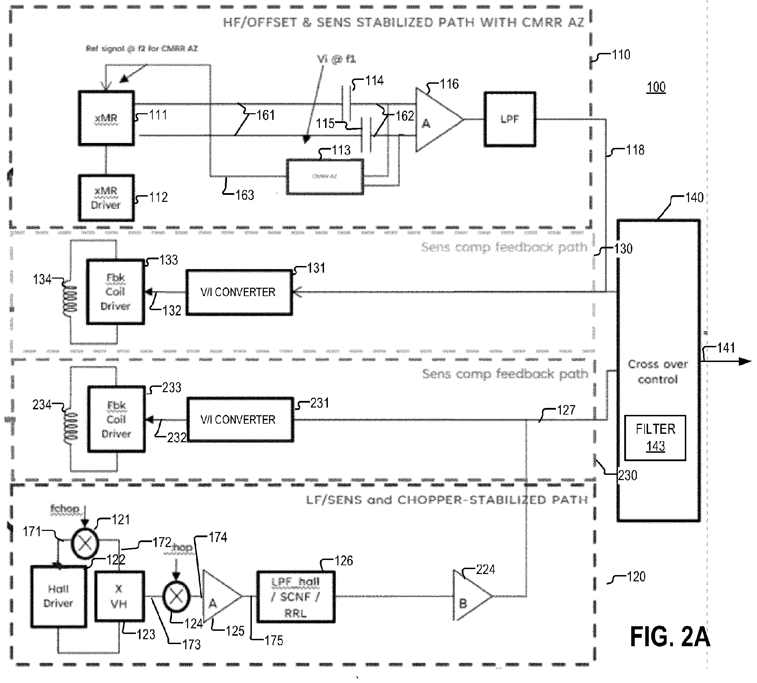

FIG. 2A is a diagram of another implementation of magnetic field sensor 100, according to aspects of the disclosure. The implementation of sensor 100 that is shown in FIG. 2A is identical to the implementation of sensor 100 that is shown in FIG. 1A, but for: (i) sensor 100 including a second feedback path 230, and (ii) signal path 120 having an amplifier 224 added to it. As illustrated, amplifier 224 is configured to generate the signal 127 by amplifying the output of low-pass filter 126. Feedback path 230 may include a voltage-to-current (V/I) converter 231, a feedback coil driver 233, and a feedback coil 234. The V/I converter 231 may be configured to receive the signal 127 and generate a control signal 232 in response. The signal 232 is provided to feedback coil driver 233 where it is used by the feedback coil driver 233 to drive the feedback coil 234. Signal 232 may specify the level of electrical current that is required to be passed through the feedback coil 234 and/or the level of feedback magnetic field that is to be generated by the feedback coil.

In some implementations, feedback coil 134 may be positioned in greater proximity to sensing bridge 111 than Hall elements 123. Similarly, feedback coil 234 may be positioned in greater proximity to Hall elements 123 than sensing bridge 111. As a result of this arrangement, feedback coil 134 may be configured to adjust the sensitivity of sensing bridge 111 without significantly affecting the operation of Hall elements 123. Similarly, as a result of this arrangement, feedback coil 234 may be used to adjust the sensitivity of Hall elements 123 without significantly affecting the operation of sensing bridge 111. Accordingly, the respective sensitivities of the signal path 110 and the signal path 120 may be independently balanced, which in turn would result in greater accuracy of the design of FIG. 2A in comparison to the design of FIG. 1A. As a result of the feedback path 230 being provided in sensor 100, the stability of the sensitivity of signal path 120 is stabilized compared to the embodiment of FIG. 1A. On the other hand, in the design of FIG. 2A, the respective gains of signal paths 110 and 120 are required to be matched. This necessitates additional trimming to be performed on the gain of signal path 120 so that it matches the gain of signal path 110. The additional trimming may be performed by adjusting the current used to drive feedback coils 134 and 234 to correct for any mismatch that there might be between a first coupling coefficient that describes the magnetic coupling between feedback coil 134 and sensing bridge 111 and a second coupling coefficient that describes the magnetic coupling between feedback coil 234 and Hall elements 123. In the example of FIG. 2A, amplifier 224 is added in order to provide a high forward gain for feedback path 230.

In the example of FIG. 2A, the output of signal path 110 is described by equation 1, which is discussed above, the output of crossover 140 is described by equation 3, which is discussed above, and the output of signal path 120 is described by equation 4:

$$S_{127} = \frac{B_{ext(LF)}}{K_{fbkHALL}*d_{HALL}} \quad (4)$$

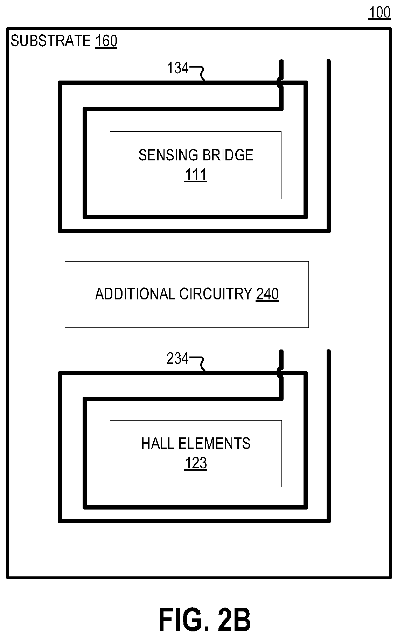

where $S_{127}$ is the value of signal 127, $B_{ext(LF)}$ is the magnitude of the low-frequency component of the external magnetic field that is being measured, $K_{fbkHALL}$ is a coupling coefficient representing the transfer of energy between the feedback coil 234 and the Hall elements 123, and $d_{HALL}$ is a scaling factor. FIG. 2B is a diagram of sensor 100 when sensor 100 is arranged in accordance with the design of FIG. 2A. The example of FIG. 2B is identical to the example of FIG. 1F, but for including additional circuitry 240, instead of additional circuitry 147, and also including the feedback coil 234. Additional circuitry 240 may include all components of sensor 100 that are shown in FIG. 2A, other than sensing bridge 111, feedback coil 134, Hall elements 123, and feedback coil 234. In the example of FIG. 2B, feedback coil 234 is implemented as a conductive trace that is formed on the substrate. Feedback coil 234 may include one or more turns, and it may be arranged to surround Hall elements 123. Although, in the example of FIG. 2B, feedback coil 234 is arranged to surround Hall elements 123, alternative implementations are possible in which feedback coil 234 is disposed to the side of Hall elements 123. Additionally or alternatively, in some instances, feedback coil 234 may be formed in greater proximity to Hall elements 123 than sensing bridge 111. In the example of FIG. 2B both of sensing bridge 111 and Hall elements 123 are arranged in a closed-loop configuration.

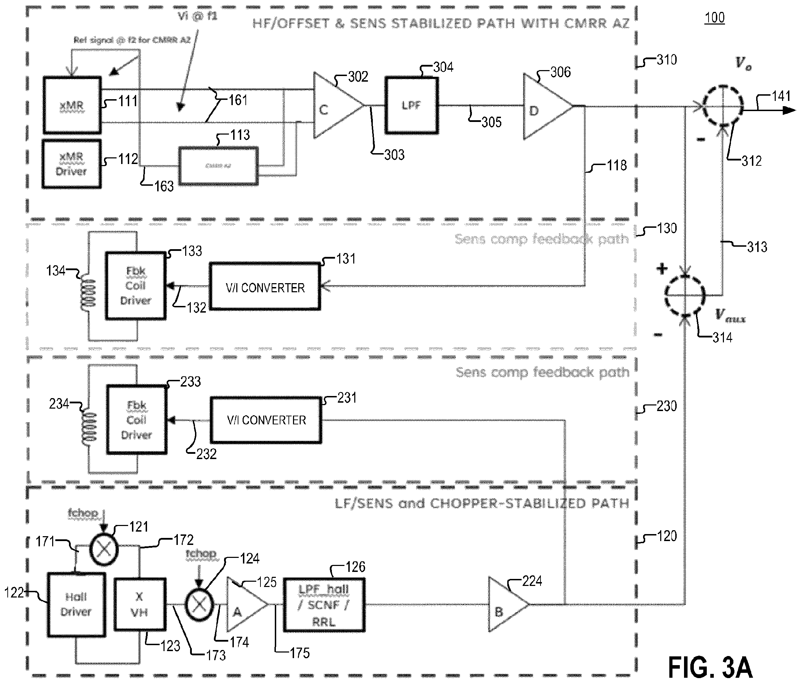

FIG. 3A is a diagram of another implementation of magnetic field sensor 100, according to aspects of the disclosure. The implementation of sensor 100 that is shown in FIG. 3A is identical to the implementation of sensor 100 that is shown in FIG. 2A, but for(i) sensor 100 including a signal path 310 instead of the signal path 110, and (ii) sensor 100 including summation circuits 312 and 314 instead of the crossover 140.

Signal path 310 may include the driver circuit 112, the sensing bridge 111, the control circuit 113, an amplifier 302, an LPF 304, and an amplifier 306. In operation, sensing bridge 111 may be configured to sense a magnetic field signal and generate a sensing signal 161 in response. The amplifier 302 may be configured to amplify the sensing signal 161 to produce an amplified signal 303. The LPF 304 may be configured to filter the signal 303 to produce a filtered signal 305. And the amplifier 306 may be configured to amplify the signal 305 to produce the signal 118. Summation circuit 314 may subtract signal 127 from signal 118 to produce a signal 313, which is representative of the offset of signal path 310. Summation circuit 312 may subtract signal 313 from signal 118 to produce the signal 141.

The operation of architecture shown in FIG. 3A may be described by equations 5-9 below:

$$S_{118} = \frac{B_{ext}+B_{off}}{K_{fbkMR}*d_{MR}} \quad (5)$$

$$S_{127} = \frac{B_{ext}}{K_{fbkHALL}*d_{hall}} \quad (6)$$

$$K_{fbkMR} * d_{MR} = K_{fbkHall} * d_{hall} = \mathrm{K_{fb}} * \mathrm{d} \quad (7)$$

$$V_{aux} = \frac{B_{ext} + B\_off}{K_{fbkMR} * d_{MR}} - \frac{\mathrm{B_{ext}}}{\mathrm{d_{hall}} * \mathrm{K_{fbhall}}} \underset{if\ (equation\ 7)is\ met}{=} \frac{B\_off}{K_{fbk} * \mathrm{d}} \quad (8)$$

$$S_{141} = S_{118} - V_{aux} = \frac{B_{ext} + B_{off}}{K_{fb} * d} - \frac{\mathrm{B_{off}}}{K_{fb} * d} = B_{ext}/(d * K_{fb}) \quad (9)$$

where $S_{118}$ is the value of signal 118, $B_{off}$ is an offset, $S_{127}$ is the value of signal 127, $S_{141}$ is the value of signal 141, $B_{ex}$ is the magnitude of the external magnetic field that is being measured, $K_{fbkMR}$ is a coupling coefficient representing the transfer of energy between the feedback coil 134 and the sensing bridge 111, KfbHall is a coupling coefficient representing the transfer of energy from feedback coil 234 and Hall elements 123, $d_{MR}$ is a scaling factor, $d_{hall}$ is a scaling factor, and d is a scaling factor.

In the example of FIG. 3A, no blocking capacitors are present in signal path 310. This is in contrast to signal path 110, which is shown in the examples of FIG. 1A and FIG. 2A. Because no blocking capacitors are present in signal path 310, an offset component $B_{off}$ is present in signal 118. The offset component $B_{off}$ is removed by summation circuits 312 and 314, which are used to combine signals 118 and 127 to produce the output signal 141. However, in order for the offset component to be successfully removed by summation circuits 312 and 314, equation 7 must hold true. In this regard, in the example of FIG. 3A, the components of sensor 100 are configured so that equation 7 would hold true. In some implementations, in order for equation 7 to hold true, signal paths 310 and 120 may be designed to have the same gain. Alternatively, in some implementations, the gains of signal paths 310 and 120 may be equalized by trimming the current used to drive feedback coils 134 and 234 to correct for any mismatch that there might be between a first coupling coefficient that describes the magnetic coupling between feedback coil 134 and sensing bridge 111 and a second coupling coefficient that describes the magnetic coupling between feedback coil 234 and Hall elements 123.

As noted above, in the example of FIG. 3A, the summation circuits 312 and 314 are used to replace the crossover 140 which is used in the examples of FIG. 1A and 2A. One advantage of using the summation circuits 312 and 314 instead of the crossover 140 is that the summation circuits 312 and 314 are less expensive to design than the filter 143, which is part of crossover 140.

In another aspect, the design shown in FIG. 3A requires the gains of signal path 310 to be matched to the gain of signal path 120, or vice versa. The gain matching may be performed by selecting the appropriate gain values for each, or at least some, of amplifiers 302, 306, 125, and 224.

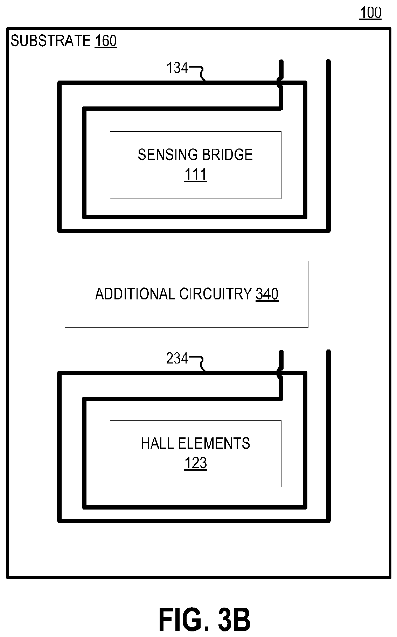

FIG. 3B is a diagram of sensor 100 when sensor 100 is arranged in accordance with the design of FIG. 3A. The example of FIG. 3B is identical to the example of FIG. 2B, but for including additional circuitry 340, instead of additional circuitry 240. Additional circuitry 340 may include all components of sensor 100 that are shown in FIG. 3A, other than sensing bridge 111, feedback coil 134, Hall elements 123, and feedback coil 234. In the example of FIG. 3B both of sensing bridge 111 and Hall elements 123 are arranged in a closed-loop configuration, and feedback coil 234 is arranged to surround Hall elements 123. In the example of FIG. 3B, feedback coil 134 may be arranged in such a way that the impact of the feedback magnetic field generated by feedback coil 134 on Hall elements 123 is negligible or ideally nonexistent. Similarly, feedback coil 234 may be arranged in such a way that the impact of the feedback magnetic field generated by feedback coil 234 on sensing bridge 111 is negligible or ideally nonexistent.

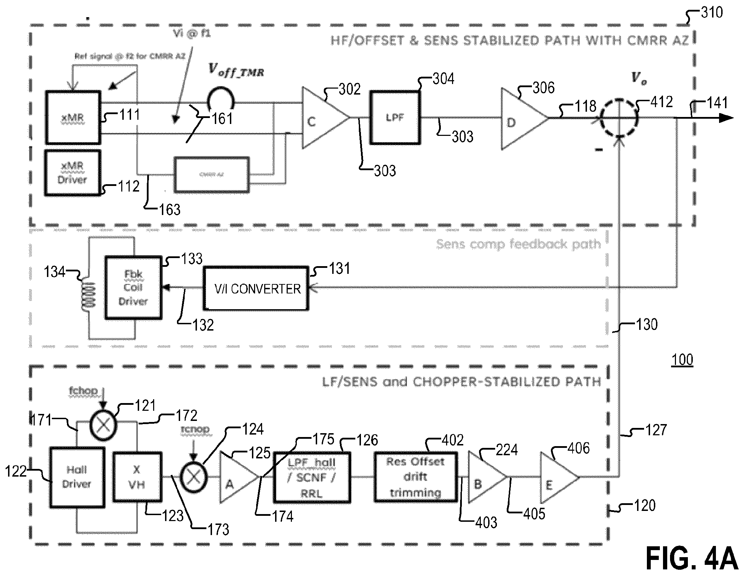

FIG. 4A is a diagram of another implementation of magnetic field sensor 100, according to aspects of the disclosure. The implementation of sensor 100 that is shown in FIG. 4A is identical to the implementation of sensor 100 that is shown in FIG. 3A, but for: (i) feedback path 230 being removed, (ii) signal path 120 including an extra trimming module 402 and an extra amplifier 406, and (iii) summation circuits 312 and 314 being replaced by a single summation circuit 412.

In the example of FIG. 4A, the trimming module 402 that is disposed between the LPF 126 and amplifier 224. Trimming module 402 may include any suitable type of circuit that is configured to remove any residual offset that remains after the chopping operation, which might be present in the output of LPF 126. In some implementations, an extra trimming module, such as the trimming module 402 may be included in any of the designs of signal path 120 at are designed with respect to FIGS. 1A, 2A, and 3A. Trimming module 402 may be configured to receive the output of LPF 126 and generate a signal 403 in response by subtracting an offset value from the output of LPF 126. In some implementations, trimming module 402 may be configured to remove offset from the output of LPF 126, which results from temperature changes, changes in humidity, mechanical stress, or other environmental conditions. Amplifier 224 may amplify the signal 403 to produce an amplified signal 405. And amplifier 406 may amplify the signal 405 to produce the signal 127. Summation circuit 412 may subtract signal 127 from signal 118 to produce the output signal 141. In the example of FIG. 4A, amplifier 406 is presented separately from amplifier 224 to make explicit the point that signal path 120 is required to have a higher gain than signal path 310 (over a certain frequency range), in order for signal path 120 to dominate at low frequencies.

In the example of FIG. 4A, the feedback path 130 is driven with the output signal 141, rather than with the signal 118 (which is the case with the designs of FIGS. 1A, 2A, and 3A). The V/I converter 131 may be configured to receive the signal 141 and generate the control signal 132 in response. Signal 132 may be provided to feedback coil driver 133 where it can be used by the feedback coil driver 133 to drive the feedback coil 134. Signal 132 may specify the level of electrical current that is required to be passed through the feedback coil 134 and/or the level of feedback magnetic field that is to be generated by the feedback coil.

The operation of the architecture shown in FIG. 4A may be described by equations 9-11 below:

$$A_{MR} \ll A_{HALL} \quad (9)$$

$$V_{off} = \left(\frac{A_{MR}}{A_{HALL}}\right) * V_{offMR} \cong 0 \quad (10)$$

$$S_{141} = \frac{B_{ext}}{d * K_{fbk}} + V_{off} = \frac{B_{ext}}{d * K_{fbk}} \quad (11)$$

where $A_{MR}$ is the gain of signal path 310, $A_{HALL}$ is the gain of signal path 120, $V_{off}$ is the offset that is present in signal 141, $V_{offMR}$ is the offset that is present in signal 161, $A_{MR}$ is the gain of signal path 310, $A_{HALL}$ is the gain of signal path 120, d is a scaling coefficient, and $K_{fbkMR}$ is a coupling coefficient that represents the transfer of energy between feedback coil 134 and the sensing bridge 111, and d is a scaling coefficient. Equation 9 indicates that signal path 120 should have a much larger gain than signal path 110. In some implementations, the gain may be 10 times larger, 100 times larger, or 1000 times larger. Equation 10 indicates that the amount of offset that is present in the output signal 141 is proportional to the ratio of the gain of signal path 310 and the gain of signal path 120. Because the gain of signal path 120 is exceedingly larger than the gain of signal path 110, the ratio would approach zero, which in turn would cause the amount of offset that is present in signal 141 to approach zero, as well. In some respects, equation 10 dictates how much larger the gain of the signal path 120 should be than the gain of signal path 110. In a typical application, the gain of signal path 110 may be about 100 times larger (*e.g.,* the gain might be in the range of 90-110).

In the design of FIG. 3A, frequency cross-overs may still be a concern. To deal with this concern, the design of FIG. 4A features a single feedback loop, which is driven by the combined signals of both signal paths -- in this regard, it will be recalled that in the architecture of FIG. 4A, the feedback path 130 is driven with the output signal 141 of sensor 100, rather than the individual output signal of only one of the signal paths in sensor 100 (*i.e.,* the signal 118). Furthermore, signal path 120, which is in charge of driving low offset since it is chopped and trimmed, will have a larger DC gain than signal path 310. As a result of the gain disparity between signal path 120 and signal path 310, it will be path 120 that will set the output signal 141, while the contribution of signal path 310 will be negligible (*e.g.,* as negligible as set by the ratio in equation 10). Therefore the output signal 141 will be offset-free provided that signal path 120 is offset free. This will be the case until the frequency response of path 120 begins to taper. At that point, signal path 310 will start to kick in to the point its gain will be higher than the gain of signal path 120 (because signal path 120 will be low-pass-filtered at that point).

In this way, and as long as the DC gain of signal path 120 is much higher than the DC gain of signal path 310, the offset of signal path 310 will be attenuated at the output.

In some implementations, LPF 126, which is part of signal path 120, may be replaced with a notch filter, which might have a more effective ripple reduction as a result of the frequency chopping that is performed in signal path 120. The notches in the response of the notch filter will be hidden by means of the signal path 310 which, at those frequencies, will have a much larger gain. In this way, by means of a single feedback loop, small frequency response ripples due to cross-over issues between signal path 310 and signal path 120 will be completely hidden in the closed loop response. In other words, the feedback loop may mask any gain changes (or uneven regions in the frequency response) of both of signal path 310 and signal path 120.

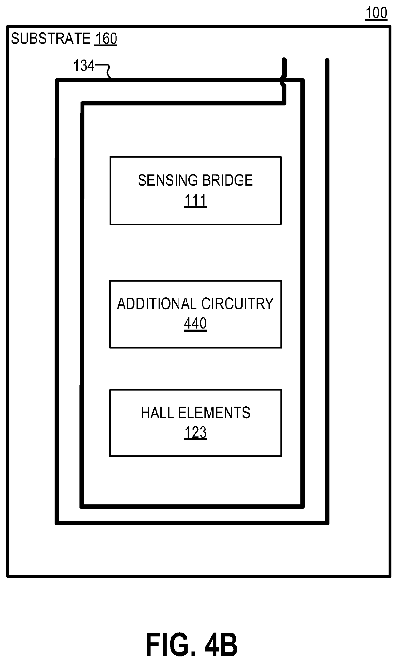

FIG. 4B is a diagram of sensor 100 when sensor 100 is arranged in accordance with the design of FIG. 4A. The example of FIG. 4B is identical to the example of FIG. 1F, but for including additional circuitry 440, instead of additional circuitry 147. Additional circuitry 340 may include all components of sensor 100 that are shown in FIG. 4A, other than sensing bridge 111, feedback coil 134, and Hall elements 123. In the example of FIG. 4B, feedback coil 134 is arranged to surround both sensing bridge 111 and Hall elements 123. In the example of FIG. 4B, both of sensing bridge 111 and Hall elements 123 are operated in a closed-loop configuration, as feedback coil 134 is driven based on the respective outputs of both of sensing bridge 111 and Hall elements 123. Furthermore, in the example of FIG. 4B, feedback coil 134 is arranged to surround both the sensing bridge 111 and the Hall elements 123.

A magnetic-field sensing element can be, but is not limited to, a Hall Effect element a magnetoresistance element, or an inductive coil. As is known, there are different types of Hall Effect elements, for example, a vertical Hall element, and a Circular Vertical Hall (CVH) element. As is also known, there are different types of magnetoresistance elements, for example, a semiconductor magnetoresistance element such as Indium Antimonide (InSb), a giant magnetoresistance (GMR) element, an anisotropic magnetoresistance element (AMR), a tunneling magnetoresistance (TMR) element, and a magnetic tunnel junction (MTJ). The magnetic field sensing element may be a single element or, alternatively, may include two or more magnetic field sensing elements arranged in various configurations, e.g., a half bridge or full (Wheatstone) bridge. Depending on the device type and other application requirements, the magnetic field sensing element may be a device made of a type IV semiconductor material such as Silicon (Si) or Germanium (Ge), or a type III-V semiconductor material like Gallium-Arsenide (GaAs) or an Indium compound, e.g., Indium-Antimonide (InSb). The phrase "set of magnetic field elements" shall mean "one or more magnetic field sensing elements".

The concepts and ideas described herein may be implemented, at least in part, via a computer program product, (e.g., in a non-transitory machine-readable storage medium such as, for example, a non-transitory computer-readable medium), for execution by, or to control the operation of, data processing apparatus (e.g., a programmable processor, a computer, or multiple computers). Each such program may be implemented in a high-level procedural or object-oriented programming language to work with the rest of the computer-based system. However, the programs may be implemented in assembly, machine language, or Hardware Description Language. The language may be a compiled or an interpreted language, and it may be deployed in any form, including as a stand-alone program or as a module, component, subroutine, or another unit suitable for use in a computing environment. A computer program may be deployed to be executed on one computer or multiple computers at one site or distributed across multiple sites and interconnected by a communication network. A computer program may be stored on a non-transitory machine-readable medium that is readable by a general or special-purpose programmable computer for configuring and operating the computer when the non-transitory machine-readable medium is read by the computer to perform the processes described herein. For example, the processes described herein may also be implemented as a non-transitory machine-readable storage medium, configured with a computer program, where upon execution, instructions in the computer program cause the computer to operate in accordance with the processes. A non-transitory machine-readable medium may include but is not limited to a hard drive, compact disc, flash memory, non-volatile memory, or volatile memory. The term unit (*e.g.,* an addition unit, a multiplication unit, *etc*.)*,* as used throughout the disclosure may refer to hardware (*e.g*., an electronic circuit) that is configured to perform a function (*e.g.,* addition or multiplication, *etc.*)*,* software that is executed by at least one processor, and configured to perform the function, or a combination of hardware and software.

Also, for purposes of this description, the terms "couple," "coupling," "coupled," "connect," "connecting," or "connected" refer to any manner known in the art or later developed in which energy is allowed to be transferred between two or more elements, and the interposition of one or more additional elements is contemplated, although not required. Conversely, the terms "directly coupled," "directly connected," etc., imply the absence of such additional elements.

As used herein in reference to an element and a standard, the term "compatible" means that the element communicates with other elements in a manner wholly or partially specified by the standard, and would be recognized by other elements as sufficiently capable of communicating with the other elements in the manner specified by the standard. The compatible element does not need to operate internally in a manner specified by the standard.

Having described preferred embodiments, which serve to illustrate various concepts, structures and techniques, which are the subject of this patent, it will now become apparent that other embodiments incorporating these concepts, structures and techniques may be used. Accordingly, it is submitted that the scope of the patent should not be limited to the described embodiments but rather should be limited only by the spirit and scope of the following claims.

## Claims

1.  A sensor, comprising:

    a first signal path including a plurality of magnetoresistance (MR) elements, the first signal path being configured to generate a first signal based, at least in part, on an output of the MR elements, the output of the MR elements being generated, at least in part, in response to an external magnetic field that is incident on the sensor and a first feedback magnetic field;
    a second signal path including one or more Hall elements, the second signal path being configured to generate a second signal based, at least in part, on an output of the Hall elements, the output of the Hall elements being generated at least in part based on the external magnetic field;
    a first feedback coil that is configured to generate the first feedback magnetic field, the first feedback coil being driven with a first drive current, the first drive current being generated, at least in part, based on the first signal; and
    a combination circuit that is configured to combine the first signal and the second signal to produce an output signal, the output signal being generated at least in part based on the first signal and the second signal.

2. The sensor of claim 1, wherein the first signal path includes one or more blocking capacitors that are configured to remove a first offset from the output of the MR elements, and the second signal path includes a modulator and a demodulator that are configured to perform frequency chopping on the output of the Hall elements to remove a second offset from the output of the Hall elements.

3. The sensor of claim 1, wherein the combination circuit is configured to combine the first signal and the second signal by adding the first signal to the second signal and filtering a resulting sum with a filter that is arranged to correct for notching that is present in combined frequency responses of the first signal path and the second signal path.

4. The sensor of claim 1, wherein the first signal path is arranged in a closed-loop configuration, the second signal path is arranged in an open-loop configuration, and the first feedback coil is positioned in greater proximity to the MR elements than the Hall elements.

5. The sensor of claim 3, wherein the first feedback coil is configured to surround the MR elements.

6. The sensor of claim 1, further comprising a second feedback coil that is configured to generate a second feedback magnetic field, the second feedback coil being driven with a second drive current, the second drive current being generated, at least in part, based on the second signal.

7. The sensor of claim 6, wherein the second feedback coil is configured to surround the Hall elements.

8. The sensor of claim 6, wherein the combination circuit includes a first summation element and a second summation element, the first summation element being configured to generate an auxiliary signal by subtracting the second signal from the first signal, and the second summation element being configured to generate the output signal by subtracting the auxiliary signal from the first signal.

9. The sensor of claim 1, wherein the first drive current is generated based on both the first signal and the second signal, the combination circuit includes a summation circuit that is configured to generate the output signal by subtracting the second signal from the first signal, the first signal path has a first gain, and the second signal path has a second gain that is two or more times greater than the first gain.

10. The sensor of claim 9, wherein the second gain is at least one order of magnitude greater than the first gain.

11. The sensor of claim 1 or 6, wherein the combination circuit is configured to generate the output signal by adding the first signal to the second signal to produce a third signal and filtering the third signal with a filter that is arranged to correct for notching in a frequency response of the third signal.

12. The sensor of claim 11, wherein the Hall elements are disposed on the side of the first feedback coil, and the first feedback coil is configured to surround the MR elements.

13. The sensor of claim 6, 8 or 11, wherein the first signal path has substantially the same gain as the second signal path.

14. The sensor of claim 6, wherein:

   the first signal path includes one or more blocking capacitors that are configured to remove a first offset that is present in an output of the MR elements, and
   the second signal path includes a modulator and a demodulator, the modulator and demodulator being configured to perform frequency chopping on an output of the Hall elements.

15. The sensor of claim 6, 8 or 11, wherein each of the MR elements includes at least one of a giant magnetoresistance (GMR) element, and each of the Hall elements includes one of a planar Hall element or a vertical Hall element.

16. The sensor of claim 6 or 8, wherein the first feedback coil is configured to surround the MR elements and the second feedback coil is configured to surround the Hall elements.

17. The sensor of claim 6 or 8, wherein the first drive current is generated independently of the second signal, and the second drive current is generated independently of the first signal.

18. The sensor of claim 9, wherein the second gain is at least two orders of magnitude greater than the first gain.

19. The sensor of claim 8 or 10, wherein the second signal path includes a modulator and a demodulator, the modulator and demodulator being configured to perform frequency chopping on an output of the Hall elements.

20. The sensor of claim 1 or 10, wherein the first feedback coil is configured to surround both the MR elements and the Hall elements.

FIG. 1A

FIG. 1B

FIG. 1C

FIG. 1D

FIG. 1E

100

SUBSTRATE 160

134

SENSING BRIDGE
111

ADDITIONAL CIRCUITRY 147

HALL ELEMENTS
123

# FIG. 1F

FIG. 2A

100

SUBSTRATE 160

134

SENSING BRIDGE
111

ADDITIONAL CIRCUITRY 240

234

HALL ELEMENTS
123

# FIG. 2B

FIG. 3A

EP 4 733 793 A2

100

SUBSTRATE 160

134

SENSING BRIDGE
111

ADDITIONAL CIRCUITRY 340

234

HALL ELEMENTS
123

## FIG. 3B

FIG. 4A

SUBSTRATE 160

100

134

SENSING BRIDGE
111

ADDITIONAL CIRCUITRY
440

HALL ELEMENTS
123

# FIG. 4B

**REFERENCES CITED IN THE DESCRIPTION**

**Patent documents cited in the description**

- US 527675